# EUROPÄISCHE PATENTSCHRIFT

(11) **EP 2 045 843 B1**
(45) Veröffentlichungstag und Bekanntmachung des Hinweises auf die Patenterteilung: **01.08.2012**
(21) Anmeldenummer: 09000312.0
(22) Anmeldetag: 01.06.2005
(51) Int. Cl.: H01L 27/32, H01L 51/52

(54) **Lichtemittierendes Bauteil mit einer Elektrodenanordnung**
Light-emitting component with an electrode assembly
Composant émettant de la lumière à l'aide d'un agencement d'électrodes

(43) Veröffentlichungstag der Anmeldung: 08.04.2009
(62) Teilanmeldung aus: 05011772.0
(73) Patentinhaber: Novaled AG, 01307 Dresden (DE)
(72) Erfinder: Birnstock, Jan, Dr., 01187 Dresden (DE); Murano, Sven, Dr., 01309 Dresden (DE)
(74) Vertreter: Bittner, Thomas L.

(56) Entgegenhaltungen:
- EP-A- 1 460 884
- WO-A-2005/008801
- WO-A-2005/015640
- GB-A- 2 392 023

## Beschreibung

Die Erfindung betrifft ein lichtemittierendes Bauteil mit einer Elektrodenanordnung zum Anlegen einer elektrischen Spannung an mehrere organische Bereiche, die zwischen einer flächig gebildeten Elektrode und einer flächig gebildeten Gegenelektrode der Elektrodenanordnung angeordnet sind und beim Anlegen der elektrischen Spannung jeweils Licht emittieren, wobei eine Anordnung mehrerer Reihenschaltungen Licht emittierender organischer Bauelemente gebildet ist und die Gegenelektrode aus segmentierten Abschnitten besteht.

### Stand der Technik

In dem Dokument DE 101 45 492 A1 wird ein lichtemittierendes Bauelement mit einem lichtemittierenden organischen Bereich beschrieben, welches mittels voneinander separierter OLED-Substrukturen (OLED - organische lichtemittierende Diode), beispielsweise in Form von flächig gebildeten Punkten oder Streifen, die Licht unterschiedlicher Wellenlänge emittieren, sowie mittels eines sich anschließenden Streuelementes Weißlicht erzeugt. Die OLED-Substrukturen werden hierbei mit Hilfe separater Elektroden kontaktiert und mittels einer Spannungsquelle angesteuert, wodurch eine optimierte Mischung der unterschiedlichen Farben erzielt werden kann.

Ein Verfahren zum Herstellen eines solchen lichtemittierenden Bauelementes erfordert notwendigerweise Verfahrensschritte, beispielsweise Maskierungsschritte, um eine Abscheidung von unterschiedlichen Materialien auf den Substrukturen des Substrates zu ermöglichen. Darüber hinaus ist gegebenenfalls die Struktur des Substrates komplexer als dies bei gewöhnlichen weißen OLEDs der Fall ist, welche direkt Weißlicht emittieren. Trotzdem bietet der Ansatz zur Erzeugung von Weißlicht auf Basis von Mischung des Lichtes, welches von den Substrukturen abgestrahlt wird, die Licht unterschiedlicher Wellenlängen emittieren, einen bedeutenden Vorteil, nämlich die Möglichkeit zum Einstellen einer Gesamtmischfarbe für das emittierte Licht mittels einer gezielten Variation der Versorgungsspannung oder des Versorgungsstromes der OLED-Substrukturen.

Falls beispielsweise Weißlicht mittels Verwendung von roten, grünen und blauen OLED-Substrukturen erzeugt wird, sind grundsätzlich alle Farbkoordinaten erreichbar, welche sich innerhalb des Dreieckes befinden, das im CIE-Farbdiagramm von den einzelnen Farben aufgespannt wird. Im Falle der Mischung des Lichtes von zwei unterschiedlichen OLED-Substrukturen, beispielsweise von Substrukturen, die gelbes und blaues Licht emittieren, sind alle Punkte zugänglich, welche sich auf einer Linie zwischen den beiden individuellen Farbpunkten befinden. Eine solche Grade verläuft idealerweise weitgehend parallel zur Kurve eines schwarzen Strahlers, wodurch sich die Einstellung der Farbtemperatur über einen weiten Bereich erzielen lässt. Eine solche Möglichkeit ist besonders erstrebenswert für Anwendungen im Bereich der Beleuchtungstechnik, da es so dem Nutzer ermöglicht wird, die Lichtquelle individuell nach seinen Wünschen zu regeln.

Ein Nachteil für eine solche OLED-basierte Weißlichterzeugung ist jedoch, dass die Verwendung von OLED-Substrukturen erhöhte Produktionskosten im Vergleich zu anderen OLED-Beleuchtungskonzepten zu Folge hat, welche beim Herstellen des OLED-Beleuchtungsbauteils ohne zusätzliche Strukturierung auskommen. Dieses ist nachteilig im Hinblick auf eine kommerzielle Anwendung solcher Beleuchtungsbauteile.

Neben den bereits erwähnten Kosten für die zusätzliche Strukturierung des Substrates bzw. die zusätzlichen Prozessschritte ist es weiterhin erforderlich, die einzelnen Farben und somit die entsprechenden Substrukturen individuell zu adressieren. Der Stand der Technik sieht in diesem Zusammenhang vor, dass eine der zur Ansteuerung in OLED-Bauteilen genutzten Elektroden strukturiert wird, beispielsweise in Form transparenter ITO-Streifen, welche dann individuell an einen Treiber angeschlossen werden, ähnlich wie dies Passivmatrix-Anzeigeelementen der Fall ist. Ein solcher Ansatz erfordert bei der Herstellung jedoch einen Verbindungsschritt zum Bonden, beispielsweise mittels einer Verklebung. Dies erfolgt üblicherweise mit hoher Präzision, beispielsweise unter Ausrichtung mittels eines Mikroskops. Darüber hinaus werden für die Verklebung üblicherweise erhöhte Temperaturen benötigt.

In den Dokumenten DE 199 16 745 A1 und DE 101 45 492 A 1 wird deshalb vorgeschlagen, für die in Form von Streifen gebildeten OLED-Substrukturen des selben Typs, die Licht gleicher Wellenlänge emittieren, einen gemeinsamen Anschluss zu verwenden, während unterschiedliche Streifentypen getrennt angeschlossen werden. Hierbei kann vorgesehen sein, dass die zur Ansteuerung genutzten Elektroden der Streifenstruktur der OLED-Substrukturen entsprechend strukturiert sind.

Auch in dem Dokument US 2002/0084993 A1 ist ein organisches Licht emittierendes Bauteil beschrieben, bei dem streifenförmige organische Bereiche, die zwischen zwei Elektroden angeordnet sind, mit streifenförmigen Elektrodenabschnitten verbunden sind, über die eine elektrische Spannung zur Ansteuerung der organischen Bereiche angelegt wird. Zueinander benachbarte streifenförmige Elektrodenabschnitte werden mit unterschiedlichen Spannungen beaufschlagt, um den jeweils zugehörigen organischen Bereich anzusteuern.

Aus dem Dokument GB 2 392 023 A ist ein Licht emittierendes Bauteil bekannt, bei dem in einer Ausführungsform eine Anordnung von zwei Reihenschaltungen mit jeweils zwei Licht emittierenden organischen Bauelementen gebildet ist. Endseitig sind die beiden Reihenschaltungen mit für die Elektroden gemeinsamen Kontaktleitungen zum Anlegen einer elektrischen Spannung gebildet.

Aus dem Dokument WO 2005/008801 A1 ist ein elektrolumineszentes Bauteil bekannt, bei dem in einer Ausführungsform mehrere Streifenelektroden jeweils eine gemeinsame Elektrode für nebeneinander gebildete organische Bereiche bilden.

### Die Erfindung

Der Erfindung liegt die Aufgabe zugrunde, ein Licht emittierendes Bauteil mit einer Elektrodenanordnung zum Ansteuern von mehreren organischen Bereichen, die beim Anlegen einer elektrischen Spannung an die Elektrodenanordnung jeweils Licht emittieren, zu schaffen, wobei die Elektrodenanordnung mit möglichst wenig Verfahrensschritten und Platz sparend herstellbar sein soll.

Diese Aufgabe wird erfindungsgemäß durch ein Licht emittierendes Bauteil nach dem Anspruch gelöst.

Ein wesentlicher Vorteil, der mit der Erfindung gegenüber dem Stand der Technik erreicht wird, besteht darin, dass die Herstellung von Bauteilen mit organischen Licht emittierenden Substrukturen zum Erzeugen von Licht unterschiedlicher Farben wesentlich vereinfacht wird. Darüber hinaus kann die Ausbeute erhöht werden. Diese Vorteile führen zu einer Verminderung der Herstellungskosten. Des Weiteren wird die elektrische Kontaktierung vereinfacht. Prozessschritte können entfallen, wodurch Kosten eingespart werden

### Ausführungsbeispiele der Erfindung

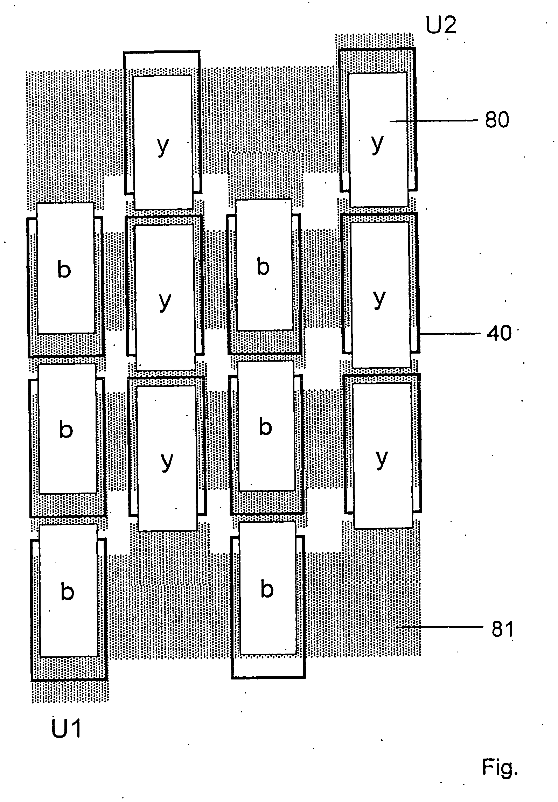

Die Erfindung wird im Folgenden anhand eines Ausführungsbeispiels unter Bezugnahme auf eine Figur näher erläutert. Die einzige Figur zeigt eine schematische Darstellung einer Elektrodenanordnung und mehrerer organischer Bereiche für ein lichtemittierendes Bauteil, wobei eine Anordnung mit mehreren Reihenschaltungen organischer Licht emittierender Bauelemente gebildet ist.

Die Figur zeigt eine schematische Darstellung einer Elektrodenanordnung und mehrerer organischer Bereiche für ein lichtemittierendes Bauteil, wobei eine Anordnung mit mehreren Reihenschaltungen organischer Licht emittierender Bauelemente gebildet ist. Selbst eine solche komplizierte Anordnung lässt sich unter Verwendung der oben beschriebenen Konstruktionsprinzipien für die Elektrodenanordnung ohne zusätzliches Aufbringen einer Isolationsschicht zum Isolieren von Teilelektroden realisieren. In der Figur sind zwei unterschiedliche Arten von organischen Bereichen "b" und "y" vorgesehen, die Licht mit zwei unterschiedlichen Farben emittieren. Es sind eine obere Elektrode 80 und eine untere Elektrode 81 gebildet, zwischen denen die organischen lichtemittierenden Bereiche angeordnet sind. Es werden die beiden Spannungen U1 und U2 angelegt.

Die untere Elektrode 81 ist in streifenförmige Segmente aufgeteilt, die nicht elektrisch verbunden sind. OLED-Segmente 40 sind aufgeteilt in die organischen Bereiche "b" und "y", welche Licht unterschiedlicher Farbe emittieren. Die obere Elektrode 80 umfasst Segmente, welche versetzt zu den OLED-Segmenten 40 aufgebracht sind, was derart erfolgt, dass mittels Versatz eine Kontaktierung der oberen Elektrode 80 mit einem benachbarten Streifen der unteren Elektrode 81 erfolgt. Hierbei kontaktiert die obere Elektrode 80 der organischen Bereiche "y" das in der Figur jeweils unterhalb angeordnete streifenförmige Segment der unteren Elektrode 81, wohingegen die obere Elektrode 80 der organischen Bereiche "b" das in der Figur jeweils oberhalb angeordnete streifenförmige Segment der unteren Elektrode 81 kontaktiert. Hierdurch entsteht eine Reihenschalten der einzelnen organischen Bereiche, wobei die Polung für die lichtemittierenden organischen Bereiche "b" und "y", unter der Voraussetzung das diese die gleiche Ausrichtung hinsichtlich des bevorzugten Ladungstransportes der Dioden zum Substrat haben, für die angelegten Spannungen U1 und U2 jeweils gegensätzlich ist. Somit wird beim Anlegen einer Spannung U1, U2 jeweils entweder der organische Bereich "b" oder der organische Bereich "y" in Vorwärtsrichtung, nämlich in Betriebsrichtung mit einer Spannung versorgt, die andersfarbig emittierenden organischen Bereiche jedoch in Sperrrichtung. Bei einer Umkehr des Potentials werden entsprechend die jeweils anderen organischen Bereiche in Betriebsrichtung oder Sperrrichtung mit einer Spannung versorgt.

Es können Rechteckspannungsimpulse verwendet werden. In Vorwärtsrichtung leuchten dann nur die organischen Bereiche "b". In Rückwärtsrichtung leuchten die organischen Bereiche "y". Mittels Einstellen von Impulslänge und Impulshöhe der Rechteckspannungsimpulse lassen sich Helligkeit und Farbe durchstimmen. Mit Hilfe der Anordnung sind Reihenschaltungen Licht emittierender organischer Bauelemente geschaffen, so dass bei Ausfall eines leuchtenden Bereiches nicht das gesamte Bauteil ausfällt.

Die unter Bezugnahme auf die Figur beschriebene Ausführungsform eines lichtemittierenden Bauteils ist auch unabhängig hiervon als selbständiges Prinzip nutzbar. In der Ausführungsform ist eine Bauform mit Elektrodenanordnungen geschaffen, die zum Ansteuern von organischen Bereichen dient, die in der Lage sind, Licht unterschiedlicher Farben zu emittieren. Bei den lichtemittierenden Bauteilen sind sich überlappende Bereiche der vorgesehenen Elektroden, außer in Abschnitten, in denen eine elektrische Kontaktierung gewünscht ist, minimiert oder sogar vollständig vermieden.

## Patentansprüche

1. Lichtemittierendes Bauteil mit einer Elektrodenanordnung zum Anlegen einer elektrischen Spannung an mehrere organische Bereiche (y; b), die zwischen einer unteren Elektrode (81) und einer oberen Gegenelektrode (80) der Elektrodenanordnung angeordnet sind und beim Anlegen der elektrischen Spannung jeweils Licht emittieren, wobei
- eine Anordnung mehrerer Reihenschaltungen Licht emittierender organischer Bauelemente gebildet ist und die Gegenelektrode (80) aus segmentierten Abschnitten besteht,
- die Elektrode (81) in Form mehrerer Streifensegmente gebildet ist, die benachbart zueinander angeordnet sind, wobei an einem Ende der Elektrode (81) ein erstes Streifensegment und an einem entgegengesetzten Ende der Elektrode (81) ein letztes Streifensegment gebildet sind, und
- die mehreren organischen Bereiche (y; b) jeweils auf einem der mehreren Streifensegmente der Elektrode (81) gebildet sind,
**dadurch gekennzeichnet, dass**
- ein Teil der mehreren organischen Bereiche (b) Licht einer Farbe emittiert und ein anderer Teil der mehreren organischen Bereiche (y) Licht einer anderen Farbe emittiert,
- mittels der mehreren Streifensegmente der Elektrode (81) für die organischen Bereiche (y; b), die quer zur Längsrichtung der mehreren Reihenschaltungen Licht emittierender organischer Bauelemente benachbart angeordnet sind, jeweils eine gemeinsame Elektrode gebildet ist,
- segmentierte Abschnitte der Gegenelektrode (80), die quer zur Längsrichtung der mehrerer Reihenschaltungen benachbart angeordnet sind, abwechselnd mit einem auf einer Seite benachbarten Streifensegment und einem auf einer gegenüberliegenden Seite benachbarten Streifensegment der Elektrode (81) in Kontakt sind, so dass der eine Teil der mehreren organischen Bereiche (b) mit dem auf der einen Seite benachbarten Streifensegment und der andere Teil der mehreren organischen Bereiche (y) mit dem auf der gegenüberliegenden Seite benachbarten Streifensegment verbunden ist, und
- die mehreren Reihenschaltungen Licht emittierender organischer Bauelemente versetzt zueinander angeordnet sind, so dass auf dem ersten Streifensegment nur der eine Teil der mehreren organischen Bereiche (b) und auf dem letzten Streifensegmente nur der andere Teil der mehreren organischen Bereiche (y) angeordnet sind.

## Claims

1. Light-emitting component with an electrode arrangement for applying an electrical voltage to a plurality of organic areas (y; b), which are arranged between a lower electrode (81) and an upper counter-electrode (80) of the electrode arrangement and which emit light when the electrical voltage is applied, wherein
- an arrangement is formed as a plurality of series circuits of light emitting organic components and the counter-electrode (80) consists of segmented portions,
- the electrode (81) is formed as a plurality of strip segments, which are arranged adjacent to each other, wherein at one end of the electrode (81) a first strip segment and at an opposite end of the electrode (81) a last strip segment is formed, and
- the plurality of organic areas (y; b) is formed on each of the plurality of strip segments of the electrode (81),
**characterized, in that**
- a part of the plurality of organic areas (b) emits light of one color and another part of the plurality of organic areas (y) emits light of another color,
- the plurality of strip segments of the electrode (81) forms a common electrode for the organic areas (y; b), which are arranged adjacent and transversely to the longitudinal direction of the plurality of series circuits of the light emitting organic components,
- the segmented portions of the counter electrode (80) are arranged adjacent and transversely to the longitudinal direction of the plurality of the series circuits, and are contacted with one adjacent strip segment on one side and an adjacent strip segment on an opposite side of the electrode (81) alternately, so that the one part of the plurality organic areas (b) is connected with one side of the adjacent strip segment and the other part of the plurality organic areas (y) is connected with the adjacent strip segment on the opposite side, and
- the plurality of series circuits of light emitting organic components are arranged staggered to each other, so that the one part of the multiple organic areas (b) is solely arranged on the first strip segment and the other part of the multiple organic areas (y) is solely arranged on the last strip segment.

## Revendications

1. Composant émetteur de lumière comprenant un agencement d'électrodes pour l'évacuation d'une tension électrique sur plusieurs zones organiques (y; b), qui sont disposées entre une électrode (81) inférieure et une contre-électrode (80) supérieure de l'agencement d'électrodes et émettent à chaque fois de la lumière lors de l'application de la tension électrique,
- un agencement de plusieurs montages en série de composants organiques émettant de la lumière étant formé et la contre-électrode (80) étant constituée de tronçons segmentés,
- l'électrode (81) étant formée sous forme de plusieurs segments de bande, lesquels sont disposés à proximité les uns des autres, un premier segment de bande et un dernier segment étant formés respectivement sur une extrémité de l'électrode (81) et sur une extrémité opposé de l'électrode (81), et
- les plusieurs zones organiques (y; b) étant formées respectivement sur l'un des plusieurs segments de bande de l'électrode (81),
**caractérisé en ce que**,
- une partie des plusieurs zones organiques (b) émet de la lumière d'une couleur et une autre partie des plusieurs zones organiques (y) émet de la lumière d'une autre couleur,
- à chaque fois une électrode commune est formée au moyen des plusieurs segments de bande de l'électrode (81) pour les zones organiques (y; b), qui sont disposées à proximité transversalement au sens longitudinal des plusieurs montages en série de composants organiques émettant de la lumière,
- des tronçons segmentés de la contre-électrode (80), qui sont disposés transversalement au sens longitudinal des plusieurs montages en série, sont en contact alternativement avec un segment de bande voisin sur un côté et un segment de bande, voisin sur un coté opposé, de l'électrode (81), de sorte qu'une partie des plusieurs zones organiques (b) est reliée au segment de bande voisin sur l'un des côtés et l'autre partie des plusieurs zones organiques (y) est reliée au segment de bande voisin sur le côté opposé, et
- les plusieurs montages en série de composants organiques émettant de la lumière sont disposés de façon décalée les uns par rapport aux autres, de sorte que seule l'une des parties des plusieurs zones (b) organiques est disposée sur le premier segment de bande et seule l'autre partie des plusieurs zones (y) organiques est disposée sur le dernier segment de bande.
